# EUROPEAN PATENT SPECIFICATION

(11) **EP 4 085 484 B1**
(45) Date of publication and mention of the grant of the patent: **16.07.2025**
(21) Application number: 20821066.6
(22) Date of filing: 13.11.2020
(51) Int. Cl.: H02S 20/32, H02S 40/22

(54) **PHOTOVOLTAIC AND LIGHT TRANSMISSION MODULATING PANEL AND ROOF FOR THE CONSTRUCTION OF ROOFS OR FACADES WITH SHADING SYSTEMS**
PHOTOVOLTAIK- UND LICHTTRANSMISSIONSMODULIERENDE PLATTE UND DACH ZUR HERSTELLUNG VON DÄCHERN ODER FASSADEN MIT BESCHATTUNGSSYSTEMEN
PANNEAU PHOTOVOLTAÏQUE DE MODULATION DE TRANSMISSION DE LUMIÈRE ET TOIT POUR LA CONSTRUCTION DE TOITS OU DE FAÇADES DOTÉS DE SYSTÈMES D'OMBRAGE

(30) Priority: 15.11.2019 IT 201900021336
(43) Date of publication of application: 09.11.2022
(73) Proprietor: ROCCAFORTE, Giacomo, 17023 Ceriale (IT)
(72) Inventor: ROCCAFORTE, Giacomo, 17023 Ceriale (IT)
(74) Representative: Balder IP Law, S.L.
(86) International application number: PCT/IB2020/060712
(87) International publication number: WO 2021/095005

(56) References cited:
- WO-A1-2019/200292
- KR-A- 20170 011 572
- US-A1- 2001 008 144
- US-A1- 2012 247 533
- US-A1- 2019 190 443

## Description

The present invention relates to a photovoltaic and light transmission modulating panel comprising a predetermined size, that is a predetermined surface extension, said panel being provided:
- in alternate position and side by side with each other, of transparent zones having a high transmissibility to light radiation and
- of areas with zero or very low transmissibility, that is with high opacity;
- the zones with high opacity being made up of a plurality of bifacial photovoltaic cells placed side by side and distributed so as to cover the entire surface extension of said zero transmissibility zones;
- the transparent zones being free of any photovoltaic cells and having a dimension of the surface which is similar or bigger than the surface of a photovoltaic cell and/or the area of the interspaces between photovoltaic cells;
- optical means for deviating and/or modulating the light radiation passing through said high transmissibility areas, to convey and/or modulate the light radiation which crosses the high transmissibility areas on regions of interest.

The term modulating the light radiation that crosses the high transmissibility zones according to the present invention means changing the quantity of light radiation which passes through the panel and is outputted onto the space behind the panel with reference to the direction of propagation of the light and in particular onto an object or an environment behind the said panel with reference to the light propagation direction against the panel.

In relation to the present invention, as it will appear more clearly from the following reference to the prior art and from the detailed description of the exemplary embodiments of the present invention the transparent zones having a high transmissibility to the light radiation is not to be confused with the spaces which are usually provided between adjacent photovoltaic cells, but is a part of the panel which has an area which is similar or bigger than the area of one or more cells positioned one beside the other in the two directions spanning the surface of the panel, this because the cross section of the passing radiation through the panel and onto the region and the objects behind the panel should allow a sufficient light energy to pass for example illuminating the said region behind the panel and also for example to allow that natural processes relating to plant growth can occur in an optimum condition of illumination and irradiation with light energy.

Panels of this type are known in the state of the art. A panel of this type is known from the document ITSV2005A000007. This document describes a roofing element for agricultural greenhouses or similar, which element comprises a first rigid transparent panel of predetermined dimensions and which has substantially transparent areas alternating with substantially opaque areas, optical means for deviating and concentrating light on the opaque areas when the sun is in a higher position compared to the horizon, and of progressive deviation and concentration of light on transparent areas when the sun is in a lower position compared to the horizon, in such a way as to modulate the heating and lighting of the greenhouse and avoid excessive temperature excursions inside it. According to a preferred embodiment, the opaque areas consist of photovoltaic modules for the production of electrical energy.

Therefore, thanks to this type of panel, the light radiation that is prevented from entering the greenhouse to reduce its effect is not wasted, but is diverted onto the photovoltaic modules and therefore the energy is recovered in the form of electric energy. This occurs when the position of the sun is higher compared to the horizon and therefore the intensity of the incident energy is greater, while the solar radiation is allowed to penetrate into the greenhouse through the transparent part of the panel when the sun is lower and therefore the energy of the incident radiation is lower.

In this embodiment according to the state of the art, the dedicated optical means for deviation and concentration of light consist of a condenser lens and in particular a Fresnel lens which is provided in front of the face of the panel exposed to the incident radiation.

Document EP2051577 describes a panel similar to that of ITSV2005A000007. Also in this document the optical means for deviating and modulating the light radiation are provided superimposed on the exposed face of the panel consisting of opaque areas provided with photovoltaic modules and transparent areas alternating with each other.

The panels according to the state of the art therefore have all the means for deviating/modulating the light radiation above the exposed face of the panel. This condition involves several drawbacks, including:
the greater exposure of optical media, or lenses to accidental damage and to atmospheric agents, in particular to UV rays;
the fact that a considerable percentage of solar radiation passes through the transparent area even in summer, or when the sun is higher compared to the horizon;
consequently, only a part of the solar radiation in the summer are diverted to the photovoltaic cells;
optical media in the form of lenses have a high dispersion and therefore reduce the efficiency of transmission by wasting a certain amount of energy.

The system has relatively high construction costs and is relatively bulky.

The state of the art comprises embodiments of photovoltaic panels having bifacial photovoltaic cells, this meaning photovoltaic cells having light to electricity converting elements on both opposite faces thereof.

Document WO2019/200292 and document US2012/247533 disclose a photovoltaic panel comprising bifacial photovoltaic cells which are placed adjacent one to the other according to a certain distribution over a surface of the panel and which photovoltaic cells are at a distance one from the other thus forming gaps or interstices which are free of the photovoltaic cells and which are transparent to light radiation. This interstices between cells have an area which is a fraction of the area of the photovoltaic cells and is not intended for transmitting through the panel a predetermined amount of light energy and for modulating this transmitted light energy in order to obtain an optimum light energy amount in the region behind the panel for predetermined purposes.

Reflection means are provided for reflecting the light incident on the said light transmitting interstices back to the rear side of the photovoltaic cells and thus for recovering otherwise lost light energy. The purpose is not for modulating light energy transmitted through the high transmissibility interstices in the region behind the panel in order to maintain light energy transmitted in accordance with predetermined levels the said energy and at the same time recovering the blended out light energy by exploiting it for electric energy generation, but the purpose of the teaching of the above documents is to recover the light energy passing through the interstices as completely as possible and to transform as much as possible of this light energy in electric energy by means of the backside of the bifacial photovoltaic cells.

A similar construction and purpose is the aim of the teaching according to document US2001/008144.

The invention is therefore based on the problem of creating a photovoltaic and light transmission modulating panel that allows to improve and overcome the drawbacks of the known panels, all thanks to a simplified and less expensive construction and at the same time the said panel also has better performances thanks to the use of bifacial photovoltaic cells instead of traditional cells.

The invention is based on the acknowledgment validated by international studies that the same climatic conditions that make arable the lands, also make the panels more efficient. In particular, it was found that the photovoltaic panels that produce the most are those in agricultural areas.

In addition, the evaporation of water by transpiration of the underlying plants creates a local and natural system for cooling the panels, increasing their performance.

In relation to agricultural applications and to safeguard the lands, it is necessary that the panels generate small shadows and this is both to prevent the shade from lingering on the plants for too long, preventing or limiting their growth, and to achieve the most diffused and homogeneous illumination on the underlying ground as possible.

The invention achieves the above purposes with a panel of the type described at the beginning and according to the preamble of the main claim which further presents the characteristics of the characterizing part.

The panel modulates the light radiation that illuminates the soil and crops during the day and during the seasons, so that it is not too low in winter and not excessive in summer. The energy of the excess light radiation is converted into further electrical energy instead of being dispersed by the shading systems in general.

The bifacial photovoltaic cells perform more if cut, as they are mainly produced now, and the current configuration allows two advantageous side effects consisting in reducing the size of the shadows and using the direct reflected light with a closer angle of incidence to the vertical in addition to the diffused one also in the rear side.

The technical specifications of the currently known bifacial cells indicate that the peak power generated by the rear of the cells is about 80% of that of the front, and that an increase in electricity generated by 25% is obtained compared to the case in which only the upper face generates the energy. However, these data always refer to the current use of these bi-facial cells which provides that the rear side is illuminated by only light reflected from various materials and therefore is indirect and optionally also by the light incident at the interstices between the adjacent photovoltaic cells.. The use of mirrors as in the present invention projects reflect the direct light radiation also on the rear side, resulting increase of electricity generated compared to what is expected in the state of the art.

The role of the reflector organ is to reflect the incident light radiation which passes through the coincident high transmissibility area interposed between two high opacity areas on which the bifacial photovoltaic modules are distributed, on the rear side of bifacial photovoltaic modules, however, this only for angles of incidence within a predetermined range of incidence angles of solar radiation.

The conditions in the different seasons are taken into consideration:
In winter, when the sun is low on the horizon (inclination of the incident solar radiation between 30 ° and 42 °),the incident light radiation passes through the area of high transmissibility provided between the two areas of high opacity and the mirrors are arranged in such a position with respect to the arrangement of the areas with high transmissibility and those with high opacity so that the light radiation can enter the interior of the environment without intercepting the mirrors.

In this way, the light radiation that passes through the high transmissibility areas is used for the environment delimited by the said panel or by a set of said panels. The light reflected from the ground or other surfaces exposed to radiation that are present in the environment is however reflected towards the rear side of the photovoltaic modules that form the areas of high opacity and electricity is generated.

In this condition, most of the energy penetrates the environment while the photovoltaic modules operate as traditional bifacial photovoltaic panels.

In Spring / Autumn, (in this case the angle of incidence increases and can assume values between 50 ° and 60 °), part of the light radiation that passes through the high transmissibility areas is intercepted by the reflector elements present under the panel and is then reflected directly against the rear side of the photovoltaic modules, while the remaining part of the radiation does not fall on the surfaces of the reflecting organs and constitutes the energy contribution to the environment.

In this case, differently to the cited prior art, part of the light energy is used for the environment and part to increase the production of electricity. The parts of the radiation that affect the reflecting organs and those that penetrate the environment are obviously in direct proportion to the height of the sun on the horizon.

In summer, all the light radiation that crosses the high transmissibility areas falls on the corresponding mirrors and is reflected directly against the rear side of the photovoltaic modules of the high opacity areas that are directly adjacent to a high transmissibility area interposed between them.

In this condition, therefore, substantially all the energy is used for the production of electricity.

The invention is set out in the appended set of claims.

According to an embodiment, the panel has at least two opaque zones between which at least one high transmissibility zone is interposed, to which at least one reflecting member is associated, which reflecting member has zones having opposite inclinations and such as to converge for certain angles of incidence of the light radiation part of said light radiation on one of said two highly opacity zones and part of said light radiation on the other of said two zones with high opacity and wherein the dimensions of the area of the high transmissibility zone is greater than the interstices between adjacent photovoltaic cells distributed over the area of the at least two opaque zones.

One embodiment provides that the high transmissibility zone has an area which, in one or in two non-parallel directions defining the surface of the panel along the said zone, is similar or bigger than approximately than the area of one or more adjacent photovoltaic cells.

One embodiment provides that each of the said areas having opposite inclination of the reflecting organ are made concave with an appropriate arc in order to concentrate the light radiation on the area coinciding with the corresponding high opacity area of the said two areas with high opacity.

An executive variant provides that each reflecting member has a discontinuous pattern between the zones thereof having different inclinations.

In a second embodiment variant, one or both of the reflecting members have holes that can have different dimensions and densities with respect to the total extension of the surface, in such a way as to further modulate the light that is reflected, and increase the diffused light in the underlying area.

Furthermore, in one embodiment, the said reflector member extends in part also in coincidence with a peripheral band of the associated zone with high opacity.

A particular construction provides that said zones with high opacity and high transmissibility are in the form of bands parallel to each other having a predetermined width and a predetermined length, having at least one of said length or width an identical extension for all the zones, and being the said zones of high opacity and high transmissibility side by side along the sides having the same extension, while the reflection member is divided into two zones having opposite inclination along a division axis essentially parallel to said sides having the same extension.

In this case, each of the two zones of the reflecting member having opposite inclination is made arched around an axis parallel to said division axis.

In all the embodiments described above, it is possible to provide that at least one of said two zones of the reflecting member having different inclinations are made of a concave shape and are formed by a plurality of modules shaped according to the faces of a polygonal solid which approximates the arched and convex shape.

Thanks to the conformation of the reflector elements, it is possible to configure them in such a way as to have the maximum angle of incidence as close as possible to 90 °, at least as regards the photovoltaic modules and to have a distribution of the light radiation between both said zones of the photovoltaic modules and between which a high transmissibility zone is interposed.

It should be noted that in addition to the shape of the reflecting surface of the reflector, in many cases there is a reflection repeated several times between the mirrors and the rear side of the photovoltaic modules, so in these cases the production of electricity is further increased .

The invention also relates to a covering element which is constituted by a combination of a plurality of said photovoltaic and light transmission modulating panels, in particular by a row of said panels placed side by side at the longitudinal sides so as to form a row of highly transmissible zones alternating with zones of high opacity that carry the photovoltaic modules.

This roofing element can for example constitute the roof of an agricultural greenhouse, this application, however, is not to be considered as limiting the application of the panel according to the present invention.

The present invention also provides for a solar energy generation plant consisting of a plurality of said photovoltaic and light transmission modulating panels and / or a plurality of said roofing elements.

Thanks to this realization, in addition to the generation of solar energy, the effect of the panel according to the present invention is to modulate the solar radiation on the underlying ground, reducing it when it is very intense and allowing to irradiate the maximum possible light energy when this is low. This has the effect of making land cultivable that is not cultivable due to the high temperature caused by solar radiation. In particular, in arid areas, the modulation of the energy transferred to the ground allows to reduce the heat of the soil and the transpiration of the plants thus allowing an improvement of the environmental conditions and therefore a recovery of the area for agricultural production.

Thanks to the increased efficiency of the panel, it is also possible to build plants even in agricultural areas on the edge of the large cities that constitute the basins of most energy consuming , avoiding having to build expensive and long electrification networks.

Thanks to the present invention, the use of bifacial photovoltaic modules has allowed to increase the production of electricity compared to traditional panels.

The particular configuration allows to increase the shadow in the environment covered by the same compared to what happens for the panels known in the state of the art when the radiation is intense and the radiation has a large angle of incidence.

The dispersion of part of the energy of the light radiation within a lens such as those provided in the known panels is obviated. Furthermore, repeated reflections occur between the reflector organs and the photovoltaic modules, which increases the efficiency.

When provided, the frame that supports the mirrors can also be made reflective, so it also contributes to repeated reflection similarly to an "optical cage".

The present invention also brings advantages as regards performances and flexibility. In the embodiments according to the state of the art, there is a specific operating limit, which is the shadow cast on the photovoltaic cells by the lenses. This means that the lenses must be small in size, consequently the light that is deflected from them is only partial and moreover a considerable part of the sun's rays penetrate into the underlying environment even in the summer. In this case, these limits disappear. This means that the same panel is much better performing both in terms of electrical producibility and for cooling the underlying environment in the summer, as well as being able to be used in many different situations without limitations.

Still according to an advantageous embodiment, the mirrors can be fixed in a frame, which can be fixed or supported in a displaceable way with respect to said panel in at least one direction, preferably in three directions perpendicular to each other and / or possibly also rotated along at least one axis. This allows to better adapt to a very different situation and / or to set different ways of use and regulations.

The use of the reflector elements allows to cut photovoltaic modules according to different dimensions, so it is possible to provide an optical system consisting of mirrors that is positioned very close to the panels. This results in a more compact panel and a greater amount of radiation spread homogeneously.

In one embodiment, the reflector members can be supported by a frame which is completely separate from the panel and can be moved with respect to the same according to different degrees of freedom.

In one embodiment, the optical system, that is the reflector members, can be mounted on a frame which has the dimensions of the panel frame and to which it is fixed at the moment of installation, since said frames are provided with reciprocal fixing elements.

The reflector members can be made of aluminium or low-cost plastic and no special plastic is required as in the case of the optical system provided with lenses, and their manufacture is much simpler and low-cost.

Finally, with reference to all the forms and executive variants described above, the high transmissibility area can be constituted by a transparent element or it can simply be an area left free between two areas with high opacity, each of which consists of a photovoltaic panel, said panels being spaced apart correspondingly to the extension provided in said direction for the high transmissibility zone.

A further advantage in the case the high opacity zones are spaced apart leaving a free space between them, if installed on open structures, they would allow rainwater to pass on the ground, allowing it to be properly distributed.

This possibility, not necessary on greenhouses, is instead important in open fields, because installing traditional PV panels it create areas where rainwater cannot access, thus creating damage to crops, or increasing irrigation costs.

The said left free zones have an area which is greater that the area of the interstices provided between adjacent photovoltaic cells, particularly the said left free zones have a dimension in one or two of two different directions spanning the area covered by the said free zones according to the definitions provided above with reference to the high transmissibility zones of the panel.

In this case, the frame of the panel carries only the photovoltaic modules grouped so as to form the two areas of high opacity, while the frame of the mirrors carries only the mirrors, but no connecting element is provided between them, if not the frame support.

Further improvements are the subject of the dependent claims.

The invention and the advantages deriving from it will be better understood from the following description of an executive example illustrated in the attached figures.

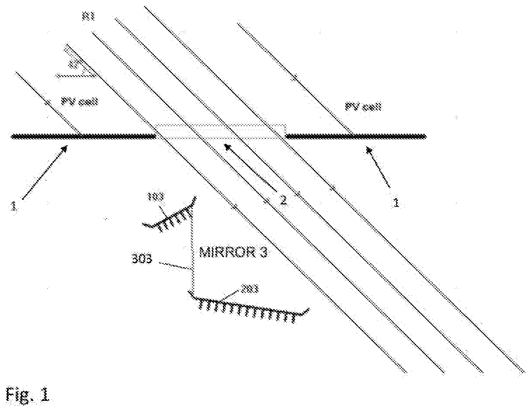

Figures 1 to 3 show a photovoltaic and light transmission modulating panel according to the present invention in its smallest form in which at least one zone with high transmissibility for the light radiation is provided, interposed on opposite sides by at least one zone of high opacity which in this case comprises bifacial photovoltaic cells and a mirror as a reflector organ which is positioned substantially aligned vertically with said zone of high transmissibility, respectively in the conditions of light radiation with angles of incidence corresponding to Winter, Spring / Autumn and Summer.

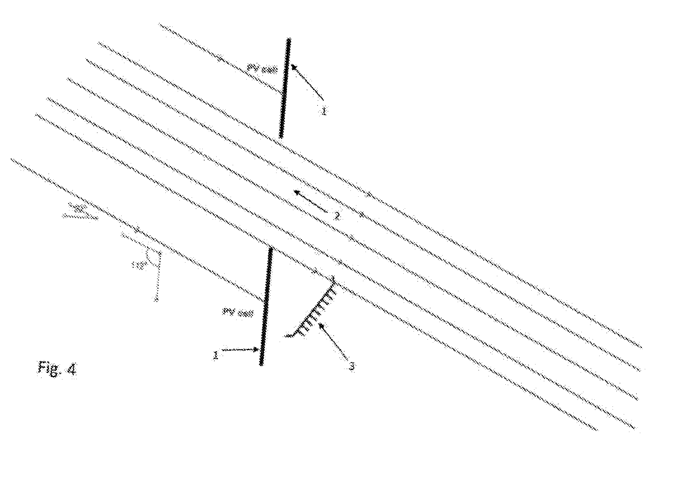

Figures 4 to 6 show, similarly to Figures 1 to 3, an application of the panel positioned vertically.

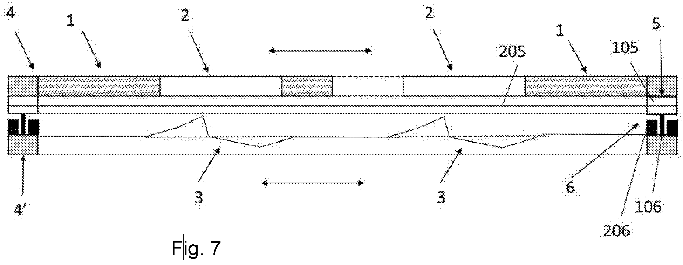

Figure 7 schematically shows an element consisting of a plurality of side-by-side bifacial photovoltaic cells forming part of a panel mounted on a frame, since the mirrors are also mounted on a separate frame fixed to the frame of the panels in a way that can be moved according to at least one degree of freedom.

With reference to Figure 1, this shows a panel according to the present invention in its minimum configuration. In this configuration, the panel comprises at least one zone with high transmissibility 2 for the light radiation, interposed on opposite sides of the same between at least one zone with high opacity indicated with 1. The zones with high opacity consist of a set of bifacial photovoltaic cells distributed over the extension of these zones. In this case the photovoltaic cells are of the so-called bi-facial type. The photovoltaic modules made with this type of cells are known in the state of the art and are able to generate electricity if they are also irradiated from the rear side.

A reflector member, for example a mirror 3, is positioned substantially aligned vertically with said high transmissibility zone.

According to an embodiment, the mirror 3 extends laterally beyond the edges of the high transmissibility zone 2 and overlaps a peripheral band of the rear face of the corresponding high opacity zone 1, along the contact edge of the latter with the high transmissibility zone 2.

The mirror 3 has two zones adjacent to each other and which are separated from each other along a separation plane 303 which is parallel to the longitudinal edge of the said zones, i.e. the edge with which the said zones 1 and 2 come into contact with each other. The two fronts 103, 203 of the mirror 3 have a different and substantially opposite to each other inclination, being oriented towards the directly adjacent zone 1 with high opacity, in order to convey the luminous radiation there by reflection.

The two zones 103, 203 of the mirror 3 are separated with a solution of continuity along said plane 303 and are each made concave.

In particular, in the illustrated embodiment, but not limitedly, the said two zones of the mirror 103, 203 are made concave.

The figures do not specify the shape of the reflecting surface precisely. The reflecting surfaces can each have at least one curvature axis, preferably, but not limitatively, an axis substantially parallel to the plane of separation 303 thereof.

In the figures, the plane 303 is oriented perpendicular to the sheet.

As can also be seen from the figures it is possible that part of the reflecting surface, for example the said two zones are spaced vertically and / or even horizontally in the transition area from one zone to the other.

Alternatively, the two zones 103 and 203 can link up directly to each other at the lateral edges of the same facing each other. In the example of the figures, the mirror is formed by the two aforementioned sections, as an alternative to a single mirror which in any case is a variant provided, in such a way as to obtain an angle of incidence of the rays reflected on the photovoltaic cells as close to normal as possible, in such a way as to be more effective and with less dispersion for reflection.

Since the dimensioning and the shape of the mirror 3 are as relevant as other quantities, in particular distance of the mirrors 3 from the plane defined by zones 1 and 2, width of these zones 1 and 2, and in particular of the zone with high transmissibility (with width we mean the dimension according to the direction perpendicular to the edges of contact between the zones 1 and 2 between them, to operate the reflections according to a certain principle depending on the angle of incidence of the light radiation it is obvious for the skilled in the art that conditions shown in the figures apply to a specific latitude, while they may vary at different latitudes).

In the following description and in the figures, R1 indicates the rays that cross the high transmissibility zone without falling on the mirrors 3, but passing beyond them; R2 indicates the rays that, passing through the high transmissibility zone, fall on the mirrors and are reflected by them towards the rear face of the high opacity zones, i.e. towards the rear faces of the photovoltaic cells provided in these zones; R3 indicates the rays that are reflected several times between the rear faces of the zones with high opacity and the mirrors.

In any case it is assumed that the latitude of the examples is constant and typical for the Ligurian area. Figure 1 shows the path of light radiation in winter. At our latitudes, considering an inclination of 20 ° of the panel with respect to the ground typical of greenhouse roofs or other structures, in winter the relative angle of incidence between the sun and the panel is between 40 ° and 50 ° as shown in Figure 1, in this case, in addition to falling on the exposed surfaces of the photovoltaic modules 1, the incident light radiation that crosses the high transmissibility zone 2 does not fall on the mirror, but penetrates the environment without hindrance. However, the diffused light of the environment is in turn reflected by the mirrors 103, 203 against the rear side of the corresponding opaque zone 1. In this case, a recovery of electricity is obtained, but substantially all the energy that passes through the transparent part is available to the environment delimited by said panel, while the photovoltaic cells mainly produce energy from their upper part exposed directly to sunlight.

In the winter, therefore, the panel behaves in a way that is completely equivalent to a traditional bifacial photovoltaic panel.

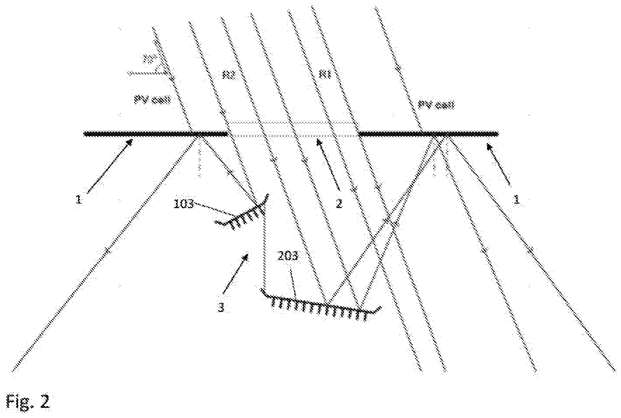

Figure 2 shows the same panel, however, in the spring or autumn season, obviously at the same latitude and conditions as the example in figure 1.

In this case the angle of incidence is included in the range from 50 to 70 °. In this case and as can be seen from the figure, only part of the radiation that passes through the high transmissibility zone falls on the environment, the other remaining part instead falls on the reflector members 3 and is reflected on the rear side of the high opacity of the corresponding panel 1. A gradual shading of the underlying environment is thus obtained, and a corresponding increase in the electricity produced by the panel.

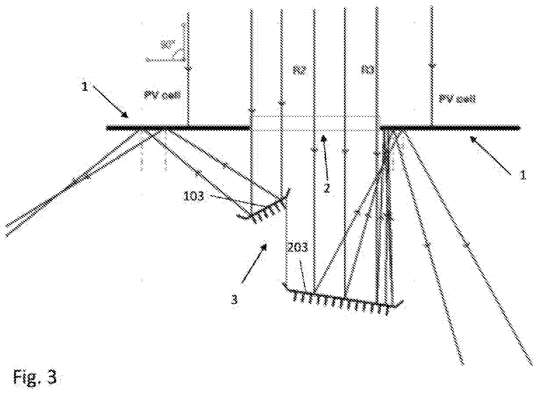

Figure 3 shows the other extreme situation in which the sun is high, so the angles of incidence considered to transmit electricity to the mirrors 3 are also close to the perpendicular.

As is evident, almost all of the light radiation, which has an angle of incidence from about 80 ° to 90 °, falls on mirror 3 or on the two areas 103 and 203 of the same and is therefore directly reflected towards the rear side of the zone with high opacity directly adjacent. In some cases, such as in the case of the light radiation propagating along the R3 direction, a multiple reflection can occur, in the sense that the radiation is reflected once from the mirror 3 towards the surface of the high opacity zone 1 and is reflected again from this towards the mirror, which in turn repeats the transmission to zone 1.

The effect illustrated so far is not only valid with the changing of the seasons, but also with the changing of the daily schedule, as it is generally based on the height that the sun assumes in the various periods.

This means that even in the summer season, a certain brightness is ensured in the morning and afternoon in the area below the panels, while it is more strongly limited in the central hours.

In general, therefore, the more intense the brightness, the more marked the shadow, and vice versa, both during the seasons and during the day, and consequently the higher the shadow, the more electricity is obtained. This modulation of brightness is absolutely not possible with traditional panels, which on the contrary produce a fixed shadow that turns out to be too large in winter and too small in summer, thus obtaining an effect that is exactly opposite and counterproductive to the present solution.

As is evident from the figures, the zone 103 of the mirror is concave.

According to an executive variant, moreover, the surface pattern of the reflecting surfaces can be obtained by constructing the mirror of each zone 103, 203 from a combination of at least two mirror elements that connect together along a longitudinal side, therefore it is possible to obtain any three-dimensional trend of the reflecting surface with a transverse section according to a curved line or according to a broken or polygonal line when the curved surface is approximated by flat mirror elements placed side by side.

The conformation of the mirror elements can be flat or concave or convex and the mirror elements can have different curvature radii and / or axes of curvature.

What has been described for the reflecting zone 103 also applies to the zone 203. In the case of figure 3, most of the light radiation that passes through the high transmissibility zone 2 is collected and projected onto the photovoltaic modules in the high opacity zones, so most of the light energy is transformed into electrical energy.

It should also be noted that the solar rays reflected by the mirror towards the photovoltaic cells are subsequently reflected by these in the underlying environment, thus always ensuring a certain degree of diffused brightness necessary for the plants.

The constructive forms can be any and an electric power generating element, or a covering element can be constituted by a plurality of panels of the type described above.

One embodiment provides a row of zones with high opacity alternating with zones with high transmissibility and arranged side by side. The zones with high transmissibility can also be simple openings. Below these, coinciding with each high transmissibility zone 1, there is provided, at a predetermined distance from the plane defined by the rear side of said zones 1 and 2, a reflecting member 3, or a mirror shaped in accordance with what has been described above.

The number of zones 1 and 2 is chosen according to considerations of expediency and according to the purposes and contingent conditions.

Different construction forms are possible and the person skilled in the art can choose the ones he seems most appropriate from the options known to the state of the art.

According to an embodiment, at least some of the mirrors 3, preferably all of them can be moved with respect to the panel comprising the areas 1 and 2 alternate with each other.

It is possible to predict displacements according to one or more degrees of freedom. In particular, it is possible to foresee three degrees of freedom of relative translation of the mirrors with respect to zones 1 and 2, for example according to the three axes of a Cartesian system for defining space and / or at least one degree of freedom of oscillation, or more degrees of oscillation according to different axes not parallel to each other, for example according to the three Cartesian axes of translation.

As is evident from figures 4 to 6, the effect achieved with the panel according to the present invention when positioned substantially horizontal or inclined with respect to the two vertical and horizontal planes as indicated in the example of figures 1 to 3, appears in a similar way even when the panel is oriented vertically. Figures 4 to 6 show the trend of the light rays in the three conditions Winter, autumn / spring, summer. From the figures it is evident how the panel according to the present invention can also operate in a vertical position.

The panel with the same principle, and related advantages and benefits, can be applied on the walls of the greenhouse or building in general, by adequately modifying the reflective part.

To achieve the same effect, i.e. maximum brightness in winter and maximum shade in summer inside the building, it is necessary to modify the reflective part, i.e. mirror 3 due to the different position that the sun takes on the walls in different seasons.

In this case, the mirror 3 consists of a single zone and can have a shape of the surface according to one or more of any of the variants described for the reflecting surface of the example according to Figures 1 to 3.

In general, the angles that the sun takes on the vertical panel during the day and the seasons are opposite to those of the panel on the roof.

For greater simplicity and clarity, both the angles that the sun takes on both the ground and the panel have been shown in the drawings.

Similarly to the panel placed on the roof according to figures 1 to 3, in the executive example of figures 4 to 6 it appears that in winter, the rays completely enter the building to ensure brightness and warmth inside. (fig. 4).

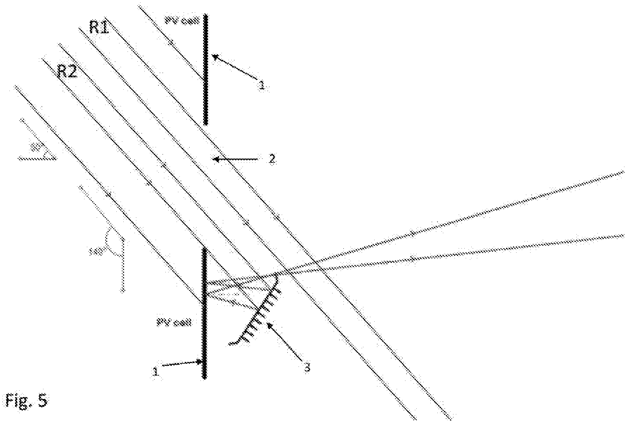

In spring and autumn, only a part proportional to the height of the sun enters the building, while the remainder is reflected on the back of the photovoltaic cells, simultaneously producing a certain percentage of shading and consequent increase in electricity production. (fig. 5)

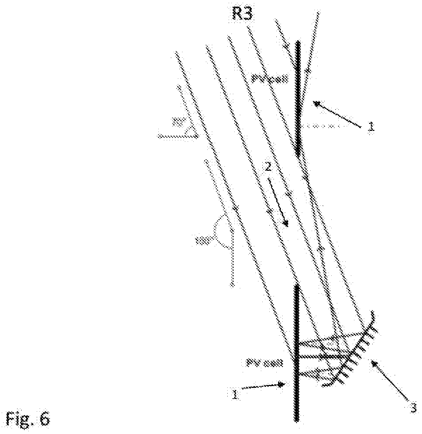

Finally, in summer, all the light radiation is reflected by the mirrors towards the photovoltaic cells, thus generating maximum shadow and maximum electricity production. (fig. 6)

The application on the walls is particularly advantageous for buildings in general and not only for greenhouses, as they constitute an automatic cooling system for buildings, significantly saving on the consumption of electricity for their conditioning.

This second application can therefore be used both in combination with the previous one in the case of greenhouses, and as a stand-alone solution for glass buildings in general. Similarly, it allows you to maximize the production of electricity from solar panels even in conditions in which due to lack of space the panels cannot be oriented lying down, but large vertical surfaces are available.

Figure 7 schematically shows an embodiment in which the mirrors 3 are supported on their own common frame 4'. Also the alternating row of high transmissibility zones 1 and high opacity zones 2 provided with the photovoltaic bifacial modules are supported by a common frame 4. The two frames are connected to each other so as to be able to translate each other in two directions perpendicular to each other and in particular the directions parallel to the longitudinal one of the panel and to the transverse one respectively.

In figure 7 this is shown schematically with a system of guides and slides indicated with 5 d in which the guide is indicated with 205 and the slides with 105 for the translation in a direction transverse to the zones 1, 2, while for that in a direction perpendicular to the sheet the translation guide system is indicated with 6 and has guides 206 in which skids 106 slide and the movement is in the longitudinal direction of the zones 1, 2.

The double arrows show the possibility of relative sliding in both directions and in the transverse direction of said zones 1 and 2.

The advantages of the present invention appear evident from the above, which derive in the first place from the fact that the optical parts are placed under the panel contrary to what happens in known panels. This avoids a projection of shadows on the photovoltaic cells due to the optical system. Furthermore, as already mentioned above, it improves the flexibility of use and performances.

In fact, in the application of the panel or of a set of these panels for the construction of greenhouse roofing elements, the present invention allows to exploit all the space between the photovoltaic cells thus ensuring a greater gain in terms of energy production, greater shading of the greenhouse in the summer and greater flexibility of use.

By positioning the optical part below the panel and not above as in the known solution, a natural protection of the optical part is obtained against atmospheric agents, dust, water and in particular ultraviolet rays, which cause a more rapid deterioration of the material, especially if plastic.

Furthermore, the optical part no longer present in the upper part of the photovoltaic panel, allows its maintenance that is periodic cleaning much more easily and without any difference compared to traditional photovoltaic panels.

As already mentioned above, the further advantages are:
Greater energy production due to the use of bifacial photovoltaic cells and to the fact that the mirrors directly reflect the light energy that falls with a certain angle of incidence on the rear side of the photovoltaic modules, so this energy is added to that generated by the irradiation of the surface directly exposed to light radiation;
Increase of the cast shadow when the angle of incidence increases, that is, it approaches the perpendicular;
Greater efficiency because the reflective optical system has no internal dispersions and therefore there is no loss of energy by the same. Moreover, in some cases, as shown in the previous description, multiple reflection phenomena are established between the mirrors and the photovoltaic modules.

Possibility of transforming the set of mirrors and frame as an optical cage, providing reflective optical elements also along the side edges.

Very compact system from a construction point of view, since the set of mirrors can be fixed very close to the element composed of the different zones 1 and 2 alternating with each other;

### Low construction costs;

Greater flexibility of use, since thanks to the fact that the optical system does not cast shadows on the photovoltaic modules, the panel according to the present invention or the element that integrates a plurality of these panels can be used for a large number of different applications.

On the one hand, as already described, a combination of panels according to the present invention can form a covering element of a greenhouse.

In addition, a panel according to the present invention or a combination thereof for the realization of elements generating electricity can also be used to regenerate an arid ground, thanks to the fact that in the periods of greater intensity of the light radiation, the projection of shadows on the ground is maximum and the light energy is conveyed almost entirely against the photovoltaic modules, while in the periods of lower intensity of the light radiation, this is transmitted on the ground and on possible crops.

The result is that in parallel with the collection of electricity, the heating effect of the land and of the crops on it is reduced, allowing the transformation of an arid land into a land useful for agricultural exploitation.

In relation to each of the above disclosed embodiments it has to be noted that the area covered by each of the high light transmission zones is greater that the area covered by the interstices between adjacent photovoltaic cells on the opaque zones.

According to an embodiment, preferably the area of each of the said high transmission zones is similar or bigger than the area of one or more photovoltaic cells.

According to still a further feature the area of each of the said high transmission zones have a similar or bigger dimension in at least one or in two of two different directions spanning the said area of the said high transmission zones.

Referring to the described exemplary embodiments these directions are a first direction parallel to the alternate sequence of the opaque and the high transmission zone 1 and 2 and a direction perpendicular to the said first direction.

## Claims

1. Photovoltaic and light transmission modulating panel comprising a predetermined size, that is a predetermined surface extension said panel being provided:
- in alternate position and side by side with each other, of transparent zones (2) having a high transmissibility to light radiation and
- of zones (1) with zero or very low transmissibility, or with high opacity;
- the zones with high opacity being made up of a plurality of bifacial photovoltaic cells placed side by side and distributed in such a way as to cover the entire surface extension of said zero transmissibility zones;
- the transparent zones being free of any photovoltaic cells and having a dimension of the area which is bigger than the area of a photovoltaic cell and/or the area of the interspaces between photovoltaic cells;
- optical means for deviating and / or modulating the light radiation passing through said high transmissibility areas, to convey and / or modulate the light radiation that crosses the high transmissibility areas on regions of interest,
the photovoltaic cells are at least partially of the so-called bifacial type, i.e. the said cells have two faces, a main front face and a rear face, each of which is able to receive light radiation and transform it into electrical energy;
the optical means for deviating and / or modulating the light radiation consist of mirrors oriented towards the rear face of the panel corresponding to the rear face of the photovoltaic cells and with a position substantially coinciding with the high transmissibility zones;
said optical means is configured, positioned and oriented in such a way that when an angle of incidence of the luminous radiation onto the panel is within a predetermined angular field from about 80° to 90°, the luminous radiation passing through the highly transmissible zones is essentially all reflected against the rear face of at least some of the high opacity zones adjacent to the high transmissibility zone and therefore against the rear face of the bifacial photovoltaic cells that compose them;
**characterized in that**,
when the angle of incidence is between 40° and 50°, all the incident light radiation that crosses the high transmissibility zones does not fall on the mirrors but penetrates the environment without hindrance;
and when the angle of incidence is about between 50° to 70° only part of the radiation that passes through the high transmissibility zones falls on the environment, the other remaining part instead falls on the mirrors and is reflected on the rear side of the high opacity zones of the corresponding panel.

2. Photovoltaic and light transmission modulating panel according to claim 1, in which at least two opaque areas are provided between which at least one area with high transmissibility is interposed to which at least one of the mirrors is associated, wherein said at least one mirror has zones of opposite inclinations and such as to converge for certain angles of incidence of the light radiation part of the light radiation on one of the two zones of high opacity and part of the said light radiation on the other of said two zones with high opacity and wherein the dimensions of the area of the high transmissibility zone is greater than the interstices between adjacent photovoltaic cells distributed over the area of the at least two opaque zones.

3. Photovoltaic and light transmission modulating panel according to claim 2, in which each of said zones of opposite inclinations is made concave with an arc so as to concentrate the light radiation on the zone coinciding with the corresponding high opacity zone of said two zones with high opacity.

4. Photovoltaic and light transmission modulating panel according to claim 2 or 3, in which each of the at least one mirror has a discontinuous pattern between the regions thereof having different inclinations.

5. Photovoltaic and light transmission modulating panel according to one or more of the preceding claims 2-4, in which said at least one mirror extends in part also in coincidence with a peripheral band of the associated high opacity zone.

6. Photovoltaic and light transmission modulating panel according to any of claims 2-5, wherein said zones with high opacity and high transmissibility are in the form of parallel bands having a predetermined width and a predetermined length, having at least one of said length or width an identical extension for all the zones, and the said zones having high opacity and high transmissibility side by side along the sides having the same extension, while the reflection member is divided into the two areas having opposite inclination along a division axis essentially parallel to said sides having identical extension.

7. Photovoltaic and light transmission modulating panel according to claim 6, wherein each of the mirrors and / or at least one of the two regions of the reflecting surface when provided have a reflecting surface which is made flat and / or arched, according to one or more different curvature axes and / or according to one or more radii of curvature, at least according to a curvature axis.

8. Photovoltaic and light transmission modulating panel according to any of claims 2-7, **characterized in that** at least a part of the reflecting surface of the at least one mirror and / or of the said two regions of the at least one mirror having different inclinations are made of a concave shape and optionally are formed by a surface or by plurality of shaped modules side by side arched and / or planes that approximates the shape of a wavy surface with three-dimensional trend and with different axes and radii of curvature.

9. Photovoltaic and light transmission modulating panel according to any of the preceding claims, in which the high transmissibility zone has an area which, in one or in two non-parallel directions defining the surface of the panel along the said zone, is bigger than approximately than the area of one or more adjacent photovoltaic cells or an area of each of the said high transmission zones which is bigger than the area of one or more photovoltaic cells or an area of each of the said high transmission zones having a bigger dimension in at least one or in two of two different directions spanning the said area of the said high transmission zones.

10. Cover element in particular for greenhouses, **characterized in that** it consists of a combination of a plurality of said panels according to one or more of the previous claims 1 to 9, said panels being arranged on at least one row of said panels side by side in correspondence of the longitudinal sides so as to form a row of zones with high transmissibility alternating with zones with high opacity which carry a plurality of photovoltaic cells distributed on the surface of said zones with high opacity.

11. Solar energy generation plant consisting of a plurality of said panels, the panels being made according to one or more of the preceding claims from 1 to 9.

12. Cover element for the modulation of light energy and the heating control of and soils **characterized by** the fact that said element is made with panels according to one or more of the previous claims 1 to 9.

13. Panel according to one or more of claims 1 to 9, **characterized in that** at least one of the mirrors is supported which can be moved according to at least one degree of freedom, optionally according to more than one degree of freedom with respect to the associated zones of high transmissibility and to the zones of high opacity.

14. Panel according to one or more of the preceding claims 1 to 9, in which one or both of the mirrors have holes that can have different dimensions and densities with respect to the total surface, in such a way as to further modulate the light that is reflected, and increase the diffused light in the area below.

## Patentansprüche

1. Photovoltaik- und lichtdurchlässigkeitsmodulierende Platte mit einer vorgegebenen Größe, das heißt einer vorgegebenen Oberflächenausdehnung, wobei die Platte bereitgestellt wird:
- mit abwechselnd und nebeneinander angeordneten transparenten Zonen (2) mit hoher Lichtdurchlässigkeit und
- Zonen (1) mit keiner oder sehr geringer Lichtdurchlässigkeit oder mit hoher Lichtundurchlässigkeit;
- wobei die Zonen mit hoher Lichtundurchlässigkeit aus einer Vielzahl bifazialer Photovoltaikzellen hergestellt sind, die nebeneinander angeordnet und so verteilt sind, dass sie die gesamte Fläche der Zonen ohne Lichtdurchlässigkeit abdecken;
- wobei die transparenten Zonen frei von Photovoltaikzellen sind und eine Flächenabmessung aufweisen, die größer ist als die Fläche einer Photovoltaikzelle und/oder die Fläche der Zwischenräume zwischen den Photovoltaikzellen;
- mit optischen Mitteln zum Ablenken und/oder Modulieren der durch die Bereiche mit hoher Lichtdurchlässigkeit hindurchtretenden Lichtstrahlung, um die durch die Bereiche mit hoher Lichtdurchlässigkeit hindurchtretende Lichtstrahlung auf interessante Bereiche zu lenken und/oder zu modulieren,
wobei die Photovoltaikzellen zumindest teilweise vom sogenannten bifazialen Typ sind, das heißt, die Zellen zwei Flächen haben, eine Hauptvorderseite und eine Rückseite, die jeweils in der Lage sind, Lichtstrahlung zu empfangen und in elektrische Energie umzuwandeln,
wobei die optischen Mittel zum Ablenken und/oder Modulieren der Lichtstrahlung aus Spiegeln bestehen, die auf die Rückseite der Platte ausgerichtet sind, die der Rückseite der Photovoltaikzellen entspricht, und deren Position im Wesentlichen mit den Zonen hoher Lichtdurchlässigkeit übereinstimmt,
wobei die optischen Mittel so ausgebildet, positioniert und ausgerichtet sind, dass bei einem Einfallswinkel der Lichtstrahlung auf die Platte innerhalb eines vorgegebenen Winkelbereichs von etwa 80° bis 90° die durch die hochdurchlässigen Zonen hindurchtretende Lichtstrahlung im Wesentlichen vollständig gegen die Rückseite von zumindest einigen der an die hochdurchlässigen Zonen angrenzenden Zonen hoher Lichtundurchlässigkeit und damit gegen die Rückseite der sie bildenden bifazialen Photovoltaikzellen reflektiert wird;
**dadurch gekennzeichnet, dass**
bei einem Einfallswinkel zwischen 40° und 50° die gesamte einfallende Lichtstrahlung, die durch die hochdurchlässigen Zonen hindurchtritt, nicht auf die Spiegel fällt, sondern ungehindert die Umgebung durchdringt;
und bei einem Einfallswinkel zwischen 50° und 70° nur ein Teil der Strahlung, die durch die hochdurchlässigen Zonen hindurchtritt, auf die Umgebung fällt, wobei der andere verbleibende Anteil stattdessen auf die Spiegel fällt und auf die Rückseite der Zonen hoher Lichtundurchlässigkeit der entsprechenden Platte reflektiert wird.

2. Photovoltaik- und lichtdurchlässigkeitsmodulierende Platte nach Anspruch 1, die mindestens zwei undurchsichtige Bereiche aufweist, zwischen denen mindestens ein Bereich mit hoher Durchlässigkeit angeordnet ist, dem mindestens einer der Spiegel zugeordnet ist, wobei der zumindest eine Spiegel Zonen mit entgegengesetzten Neigungen aufweist und bei manchen Einfallswinkeln der Lichtstrahlung einen Teil der Lichtstrahlung auf eine der beiden Zonen mit hoher Lichtundurchlässigkeit und einen Teil der Lichtstrahlung auf die andere der beiden Zonen mit hoher Lichtundurchlässigkeit konvergieren lässt, und wobei die Abmessungen der Fläche der Zone mit hoher Durchlässigkeit größer sind als die Zwischenräume zwischen benachbarten Photovoltaikzellen, die über die Fläche der mindestens zwei undurchsichtigen Zonen verteilt sind.

3. Photovoltaik- und lichtdurchlässigkeitsmodulierende Platte nach Anspruch 2, bei der jede der Zonen mit entgegengesetzten Neigungen konkav mit einem Bogen ausgebildet ist, um die Lichtstrahlung auf die Zone zu konzentrieren, die mit der entsprechenden Zone mit hoher Lichtundurchlässigkeit der beiden Zonen mit hoher Lichtundurchlässigkeit zusammenfällt.

4. Photovoltaik- und lichtdurchlässigkeitsmodulierende Platte nach Anspruch 2 oder 3, bei der jeder Spiegel des wenigstens einen Spiegels zwischen seinen Bereichen mit unterschiedlichen Neigungen ein diskontinuierliches Muster aufweist.

5. Photovoltaik- und lichtdurchlässigkeitsmodulierende Platte nach einem oder mehreren der Ansprüche 2-4, bei der sich der wenigstens eine Spiegel teilweise auch in Übereinstimmung mit einem Randstreifen der zugehörigen Zone mit hoher Lichtundurchlässigkeit erstreckt.

6. Photovoltaik- und lichtdurchlässigkeitsmodulierende Platte nach einem der Ansprüche 2-5, bei der die Zonen mit hoher Lichtundurchlässigkeit und hoher Durchlässigkeit die Form paralleler Bänder mit einer vorgegebenen Breite und einer vorgegebenen Länge haben, wobei mindestens eine der Längen oder Breiten für alle Zonen die gleiche Ausdehnung hat und die Zonen mit hoher Lichtundurchlässigkeit und hoher Durchlässigkeit Seite an Seite entlang der Seiten mit der gleichen Ausdehnung liegen, während das Reflexionselement entlang einer Teilungsachse, die im Wesentlichen parallel zu den Seiten mit der gleichen Ausdehnung ist, in zwei Bereiche mit entgegengesetzter Neigung unterteilt ist.

7. Photovoltaik- und lichtdurchlässigkeitsmodulierende Platte nach Anspruch 6, bei der jeder der Spiegel und/oder mindestens einer der beiden Bereiche der reflektierenden Oberfläche, sofern vorhanden, eine reflektierende Oberfläche aufweist, die flach ausgebildet ist und/oder gemäß einer oder mehreren unterschiedlichen Krümmungsachsen und/oder gemäß einem oder mehreren Krümmungsradien, zumindest gemäß einer Krümmungsachse, gewölbt ausgebildet ist.

8. Photovoltaik- und lichtdurchlässigkeitsmodulierende Platte nach einem der Ansprüche 2-7, **dadurch gekennzeichnet, dass** mindestens ein Teil der reflektierenden Oberfläche des wenigstens einen Spiegels und/oder der beiden Bereiche des wenigstens einen Spiegels, die unterschiedliche Neigungen haben, eine konkave Form aufweist und optional aus einer Fläche oder aus einer Vielzahl nebeneinander angeordneter gewölbter Module gebildet ist, die sich der Form einer gewellten Oberfläche mit dreidimensionalem Verlauf und mit unterschiedlichen Krümmungsachsen und Krümmungsradien annähert bzw. annähern.

9. Photovoltaik- und lichtdurchlässigkeitsmodulierende Platte nach einem der vorhergehenden Ansprüche, bei der die Zone mit hoher Durchlässigkeit eine Fläche aufweist, die in einer oder in zwei nicht parallelen Richtungen, die die Oberfläche der Platte entlang dieser Zone definieren, größer ist als ungefähr die Fläche einer oder mehrerer benachbarter Photovoltaikzellen und/oder als eine Fläche jeder der Zonen mit hoher Durchlässigkeit, die größer ist als die Fläche einer oder mehrerer Photovoltaikzellen oder als eine Fläche jeder der Zonen mit hoher Durchlässigkeit, die in mindestens einer oder in zwei von zwei unterschiedlichen Richtungen, die die Fläche der Zonen mit hoher Durchlässigkeit überspannen, eine größere Abmessung aufweist als die Photovoltaikzelle.

10. Abdeckelement, insbesondere für Gewächshäuser, **dadurch gekennzeichnet, dass** es aus einer Kombination mehrerer der genannten Platten gemäß einem oder mehreren der vorhergehenden Ansprüche 1 bis 9 besteht, wobei die Platten in mindestens einer Reihe der Platten nebeneinander entsprechend den Längsseiten angeordnet sind, um eine Reihe von Zonen mit hoher Lichtdurchlässigkeit zu bilden, die sich mit Zonen mit hoher Lichtundurchlässigkeit abwechseln, die mehrere auf der Oberfläche der Zonen mit hoher Lichtundurchlässigkeit verteilte Photovoltaikzellen tragen.

11. Anlage zum Erzeugen von Solarenergie, bestehend aus einer Vielzahl der genannten Platten, wobei die Platten nach einem oder mehreren der vorhergehenden Ansprüche 1 bis 9 hergestellt sind.

12. Abdeckelement zum Modulieren der Lichtenergie und zum Wärmeregulieren von trockenen Böden, **dadurch gekennzeichnet, dass** das Element aus Platten gemäß einem oder mehreren der vorhergehenden Ansprüche 1 bis 9 hergestellt ist.

13. Platte nach einem der Ansprüche 1 bis 9, **dadurch gekennzeichnet, dass** mindestens einer der Spiegel gelagert ist und gemäß wenigstens einem Freiheitsgrad, optional gemäß mehr als einem Freiheitsgrad, gegenüber den zugehörigen Zonen hoher Transmission und den Zonen hoher Lichtundurchlässigkeit beweglich ist.

14. Platte nach einem oder mehreren der vorhergehenden Ansprüche 1 bis 9, bei der einer oder beide der Spiegel Löcher aufweisen, die gegenüber der gesamten Oberfläche unterschiedliche Abmessungen und Dichten haben können, um das reflektierte Licht weiter zu modulieren und das diffuse Licht im darunterliegenden Bereich zu erhöhen.

## Revendications

1. Panneau de modulation de transmission photovoltaïque et lumineuse comprenant une taille prédéterminée qui est une extension de surface prédéterminée, ledit panneau étant prévu :
- dans une position alternée et côte à côte les unes avec les autres, avec des zones (2) transparentes présentant une haute transmissibilité au rayonnement lumineux et
- avec des zones (1) avec une transmissibilité nulle ou très basse, ou avec une opacité élevée ;
- les zones avec une opacité élevée étant composées d'une pluralité de cellules photovoltaïques bifaces placées côte à côte et distribuées de manière à couvrir la totalité de l'extension de surface desdites zones à transmissibilité nulle ;
- les zones transparentes étant libres de toute cellule photovoltaïque et présentant une dimension du secteur qui est supérieure au secteur d'une cellule photovoltaïque et/ou au secteur des espaces intermédiaires entre des cellules photovoltaïques ;
- un moyen optique pour dévier et/ou moduler le rayonnement lumineux passant à travers lesdits secteurs à haute transmissibilité, pour acheminer et/ou moduler le rayonnement lumineux qui traverse les secteurs à haute transmissibilité sur des régions d'intérêt,
les cellules photovoltaïques sont au moins partiellement de ce que l'on appelle le type biface, c'est-à-dire que lesdites cellules présentent deux faces, une face avant principale et une face arrière, dont chacune est à même de recevoir un rayonnement lumineux et de le transformer en une énergie électrique ;
le moyen optique pour dévier et/ou moduler le rayonnement lumineux consiste en des miroirs orientés vers la face arrière du panneau correspondant à la face arrière des cellules photovoltaïques et avec une position coïncidant substantiellement avec les zones à haute transmissibilité ;
ledit moyen optique est configuré, positionné et orienté de sorte que lorsqu'un angle d'incidence du rayonnement lumineux sur le panneau est à l'intérieur d'un champ angulaire prédéterminé d'environ 80° à 90°, le rayonnement lumineux passant à travers les zones à haute transmissibilité est essentiellement réfléchi entièrement contre la face arrière d'au moins certaines des zones à opacité élevée adjacentes à la zone à haute transmissibilité et par conséquent contre la face arrière des cellules photovoltaïques bifaces qui les composent ;
**caractérisé en ce que**,
lorsque l'angle d'incidence est entre 40° et 50°, la totalité du rayonnement lumineux incident qui traverse les zones à haute transmissibilité n'atteint pas les miroirs mais pénètre l'environnement sans obstacle ;
et lorsque l'angle d'incidence est entre 50° et 70°, seule une partie du rayonnement qui traverse les zones à haute transmissibilité atteint l'environnement, l'autre partie restante atteint, au lieu de cela, les miroirs et est réfléchie sur la face arrière des zones à opacité élevée du panneau correspondant.

2. Panneau de modulation de transmission photovoltaïque et lumineuse selon la revendication 1, dans lequel au moins deux secteurs opaques sont prévus entre lesquels au moins un secteur avec une haute transmissibilité est intercalé auquel au moins l'un des miroirs est associé, dans lequel ledit au moins un miroir présente des zones d'inclinaisons opposées et de manière à faire converger, pour certains angles d'incidence de la partie de rayonnement lumineux, une partie du rayonnement lumineux vers l'une des deux zones à opacité élevée et une partie dudit rayonnement lumineux vers l'autre desdites deux zones avec une opacité élevée et dans lequel les dimensions du secteur de la zone à haute transmissibilité est supérieure aux interstices entre des cellules photovoltaïques adjacentes réparties dans le secteur des au moins deux zones opaques.

3. Panneau de modulation de transmission photovoltaïque et lumineuse selon la revendication 2, dans lequel chacune desdites zones d'inclinaisons opposées est rendue concave avec un arc de manière à concentrer le rayonnement lumineux sur la zone coïncidant avec la zone à opacité élevée correspondante parmi lesdites deux zones avec une opacité élevée.

4. Panneau de modulation de transmission photovoltaïque et lumineuse selon la revendication 2 ou 3, dans lequel chacun des au moins un miroir présente un motif discontinu entre les régions de celui-ci présentant des inclinaisons différentes.

5. Panneau de modulation de transmission photovoltaïque et lumineuse selon une ou plusieurs des revendications précédentes 2-4, dans lequel ledit au moins un miroir s'étend en partie également de façon à coïncider avec une bande périphérique de la zone à opacité élevée associée.

6. Panneau de modulation de transmission photovoltaïque et lumineuse selon l'une quelconque des revendications 2-5, dans lequel lesdites zones avec une opacité élevée et une haute transmissibilité sont sous la forme de bandes parallèles présentant une largeur prédéterminée et une longueur prédéterminée, au moins l'une desdites longueur ou largeur présentant une extension identique pour toutes les zones, et lesdites zones présentant une opacité élevée et une haute transmissibilité côte à côte le long des côtés présentant la même extension, tandis que l'élément de réflexion est divisé en les deux secteurs présentant des inclinaisons opposées le long d'un axe de division essentiellement parallèle auxdits côtés présentant une extension identique.

7. Panneau de modulation de transmission photovoltaïque et lumineuse selon la revendication 6, dans lequel chacun des miroirs et/ou au moins l'une des deux régions de la surface réfléchissante lorsqu'elles sont prévues présentent une surface réfléchissante qui est rendue plate et/ou arquée, en fonction d'un ou plusieurs axes de courbure différents et/ou en fonction d'un ou plusieurs rayons de courbure, au moins en fonction d'un axe de courbure.

8. Panneau de modulation de transmission photovoltaïque et lumineuse selon l'une quelconque des revendications 2-7, **caractérisé en ce qu'**au moins une partie de la surface réfléchissante du au moins un miroir et/ou desdites deux régions du au moins un miroir présentant des inclinaisons différentes sont fabriqués dans une forme concave et optionnellement sont formés par une surface ou par une pluralité de modules formés côte à côté arqués et/ou plats qui se rapproche de la forme d'une surface ondulée avec une tendance tridimensionnelle et avec des axes et des rayons de courbure différents.

9. Panneau de modulation de transmission photovoltaïque et lumineuse selon l'une quelconque des revendications précédentes, dans lequel la zone à haute transmissibilité présente un secteur qui, dans une ou dans deux directions non parallèles définissant la surface du panneau le long de ladite zone, est supérieur à approximativement au secteur d'une ou plusieurs cellules photovoltaïques adjacentes ou un secteur de chacune desdites zones à haute transmissibilité qui est supérieur au secteur d'une ou plusieurs cellules photovoltaïques ou un secteur de chacune desdites zones à haute transmissibilité présentant une dimension supérieure dans au moins une ou dans deux parmi deux directions différentes couvrant ledit secteur desdites zones à haute transmissibilité.

10. Élément de recouvrement en particulier pour des serres, **caractérisé en ce qu'**il consiste en une combinaison d'une pluralité desdits panneaux selon une ou plusieurs des revendications précédentes 1 à 9, lesdits panneaux étant agencés sur au moins une rangée desdits panneaux côte à côte en correspondance avec les côtés longitudinaux de manière à former une rangée de zones avec une haute transmissibilité alternant avec des zones avec une opacité élevée qui portent une pluralité de cellules photovoltaïques distribuées sur la surface desdites zones avec une opacité élevée.

11. Centrale de production d'énergie solaire consistant en une pluralité desdits panneaux, les panneaux étant conçus selon une ou plusieurs des revendications précédentes 1 à 9.

12. Élément de recouvrement pour la modulation d'énergie lumineuse et la commande de chauffage de sols arides **caractérisé par le fait que** ledit élément est conçu avec des panneaux selon une ou plusieurs des revendications précédentes 1 à 9.

13. Panneau selon une ou plusieurs des revendications précédentes 1 à 9, **caractérisé en ce qu'**au moins l'un des miroirs est soutenu qui peut être déplacé en fonction d'au moins un degré de liberté, optionnellement en fonction de plus d'un degré de liberté par rapport aux zones associées à haute transmissibilité et aux zones à opacité élevée.

14. Panneau selon une ou plusieurs des revendications précédentes 1 à 9, dans lequel l'un ou les deux miroirs présentent des orifices qui peuvent présenter des dimensions et des densités différentes par rapport à la surface totale, de manière à moduler davantage la lumière qui est réfléchie et augmenter la lumière diffusée dans le secteur en-dessous.
